## Europäisches Patentamt
## European Patent Office
## Office européen des brevets

(19)

(11) Publication number: **0 016 368**
**B1**

(12) **EUROPEAN PATENT SPECIFICATION**

(45) Date of publication of patent specification: 14.09.83

(21) Application number: 80101061.2

(22) Date of filing: 03.03.80

(51) Int. Cl.³: **H 05 K 13/04,**
**H 01 L 21/68, H 01 L 21/98**

(54) Component mounting apparatus.

(30) Priority: 05.03.79 JP 25808/79

(43) Date of publication of application:
01.10.80 Bulletin 80/20

(45) Publication of the grant of the patent:
14.09.83 Bulletin 83/37

(84) Designated Contracting States:
DE FR GB NL

(56) References cited:
DE - A - 2 253 978
GB - A - 2 025 - 804
US - A - 4 116 348

(73) Proprietor: Matsushita Electric Industrial Co., Ltd.
1006, Oaza Kadoma
Kadoma-shi Osaka-fu, 571 (JP)

(72) Inventor: Taki, Yasuo
2-51-7. Nishifunahashi
Hirakata-shi Osaka-fu (JP)
Inventor: Mori, Kazuhiro
16-17, Myokenzaka 3-chome
Katano-shi Osaka-fu (JP)
Inventor: Araki, Shigeru
4-5, Aoyama 3-chome
Katano-shi Osaka-fu (JP)

(74) Representative: Eisenführ & Speiser
Martinistrasse 24
D-2800 Bremen 1 (DE)

Courier Press, Leamington Spa, England

## Component mounting apparatus

The present invention generally relates to an apparatus for mounting electronic parts and components, and more particularly, to an apparatus for engaging microelectronic components or the like with electronic circuit boards, etc.

Conventionally, there have been employed two methods for engaging, with a circuit board or substrate (hereinafter referred to as substrate), microelectronic components (hereinafter referred to as chip components) of a leadless type such as chip type resistor, chip type ceramic capacitor. One of the methods is that bonding agent or solder in a creamy state is applied onto the substrate by a screen printing method, or a dispenser method and thereafter, the chip components are temporarily fixed in various locations on the substrate to solder the electrodes of the chip components on the predetermined circuit locations of the substrate. The other method thereof is such that solder layers are formed in advance in the engaging locations of the chip components in the substrate circuit. Adhesive flux is applied onto the substrate circuit face from above. Then, the chip components are temporarily fixed, by the adhesive force of the flux, to the given locations of the substrate. The solder layers on the substrate are heated to solder the electrodes of the chip components on the predetermined circuit locations of the substrate. However, according to the former method, the bonding material and the creamy solder are required to be applied in advance onto the predetermined locations and a coating apparatus such as screen printing press or the like is required as an independent process of the chip component engagement. Moreover, since a process for applying adhesive material such as bonding material, creamy solder or the like is separated from the engaging process for the chip components, there are many problems involved, for example, requirements of extra care in the handling of the adhesive substrate between these processes. Meanwhile, in the latter method, although a simple apparatus will meet the purpose to apply the flux on the substrate circuit face, there are still such disadvantages that another apparatus is required, and that particular care has to be directed to the handling of the substrate when the flux has been applied over the entire face of the substrate circuit face, since the substrate is adhesive, while, when the solder layers have been heated after the engagement of the chip components for soldering, the flux is evaporated, thus generating smoke and unpleasant smell, or the chip components temporarily fixed in the predetermined locations of the substrate are positionally deviated.

From US—A—4,116,348 an apparatus for mounting electronic components onto a substrate was known, including

component locating means for picking up electronic components and placing them onto a first substrate;

substrate support means for supporting said substrate at a predetermined location relative to said component locating means, said substrate support means being provided with means for altering the relative x, y-location thereof with respect to said component locating means;

component feeding means provided with a plurality of component feeding devices for sequentially feeding the components to be picked up by said component locating means;

and driving means for driving said component feeding means which causes the plurality of component feeding devices to more relatively with respect to said component locating means, to bring said component feeding means in a predetermined order, into a position at which the required component can be picked up by said component locating means.

It is the object of the present invention to not only combine mounting of the components at the substrate with bonding same at their respective locations by a stepping-through procedure as generally known from DE—A 2,253,978, but to also ensure easy, safe, and reliable supply of the components to the locating means.

According to the present invention this object if accomplished by improving the aforementioned apparatus such that

1. a) said components are accommodated on and spaced at predetermined intervals along component accommodating tapes;

b) said component feeding devices include means for feeding said tapes by predetermined pitches, corresponding to said predetermined intervals;

2. a) a bonding agent applying means is provided for supplying bonding agent to component mounting locations on a substrate;

b) said bonding agent applying means is located at a predetermined interval from said component locating means;

3. said substrate support means is adapted to support a second substrate adjacent the bonding agent applying means at an interval from the first substrate corresponding to said predetermined interval between said bonding agent applying means and said component locating means for corresponding x—y location alteration and is further provided with means independent of said means for altering the x—y location for advancing the second substrate over said predetermined interval and simultaneously bringing a third substrate into the position previously occupied by the second substrate.

The simultaneous movement of two substrates, of which one is being supplied with a bonding agent at predetermined locations, while the other is being equipped with the electronic components at the identical locations, greatly facilitates the assembling work, and ensures registration of the locations where bonding agent is applied, and the electronic components are mounted. The electronic components are accommodated on (or preferably within) accommodating tapes, spaced apart by certain intervals. Thereby, chip component feeding is stabilized, and jamming or chipping of the components, damages to electrodes etc. is overcome. Moreover, handling of the components is facilitated, and mixing of different components is avoided. Finally, equipping the mounting apparatus, and exchanging the type of components the apparatus is equipped with, is also greatly facilitated.

Here follows a description of the preferred embodiments with reference to the accompanying drawings, in which:

Fig. 1 is a perspective view of an electronic component mounting apparatus according to one preferred embodiment of the present invention;

Fig. 2 is a schematic side elevational view of the apparatus of Fig. 1;

Fig. 3 is a top plan view showing one example of taped chip components;

Fig. 4 is a side sectional view of the taped chip components of Fig. 3;

Fig. 5 is a view similar to Fig. 3, but shows another example of the taped chip components;

Fig. 6 is a side sectional view of the taped chip components of Fig. 5;

Fig. 7 is a perspective view showing the appearance of the taped chip components;

Fig. 8 is a fragmentary perspective view of a taping cassette;

Fig. 9 is a side sectional view of the taping cassette of Fig. 8;

Fig. 10 is a side elevational view of the taping cassette of Fig. 8; and

Fig. 11 is a partial cross-sectional view of the taping cassette of Fig. 8.

Before the description of the present invention proceeds, it is to be noted that like parts are designated by like reference numerals throughout several view of the accompanying drawings.

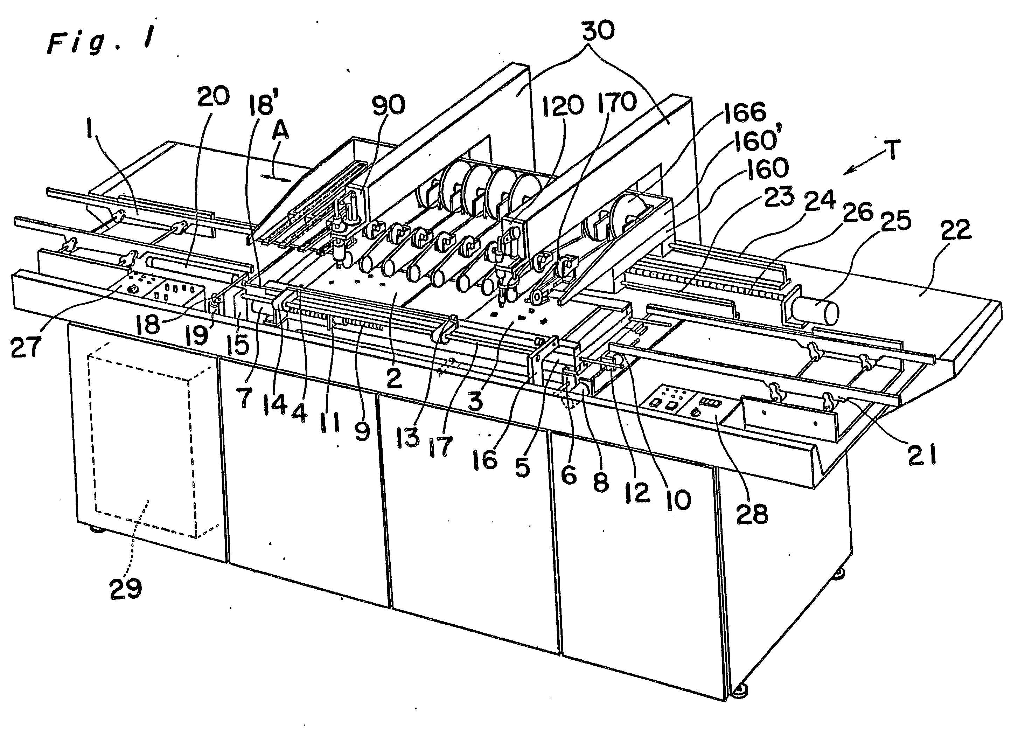

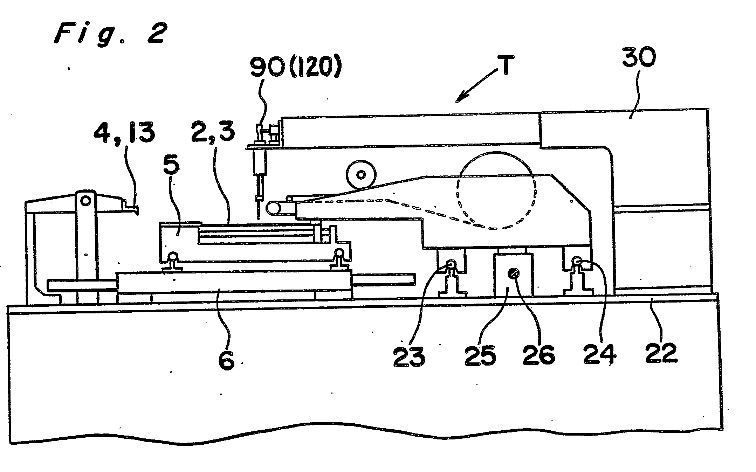

Referring now to the drawings, there is shown in Figs. 1 and 2 an electronic component mounting apparatus T according to one preferred embodiment of the present invention.

The apparatus T generally includes a bonding agent coating apparatus 90 for feeding bonding agent to chip component engaging positions on a substrate, a chip component engaging unit 120 disposed at a given interval from the bonding agent coating apparatus for placing electronic components on the bonding agent applied to the substrate, a chip component feed unit 160 provided with a row of component feed apparatuses each being adapted to sequentially feed, in one line, the chip components to be engaged in the chip component engaging unit, a chip component feed unit driving unit 30 for moving the plural component feed apparatuses to the chip component engaging unit to bring the chip component feed apparatuses, in a given order, to the component taking-out position of the chip component engaging unit 120, and a substrate support unit 5 for supporting the substrates at the same intervals as the given intervals between the bonding agent coating apparatus and the chip component engaging unit, and having a means for varying its relative position with respect to the chip component engaging unit and the bonding agent coating apparatus. The bonding agent coating for temporarily securing the chip components to the substrate and the engagement of the chip components to the substrate and the engagement of the chip components with the bonding agent on said substrate are thus performed within the same apparatus. Each of the apparatuses and units referred to above is described in detail hereinbelow with reference to the drawings.

In Figs. 1 and 2, a loader apparatus 1 is adapted to automatically feed circuit substrates into the central portion of an electronic component engaging apparatus as shown with substrates 2 and 3 in a known manner. The substrates provided by the loader apparatus 1 are fed, onto the upper table 5 of a XY stand disposed at the apparatus central portion, by substrate carrying pawls 4 and are disposed in the position of the substrates 2 and 3. The upper table 5 and the lower table 6 of the XY stand are driven, respectively, by pulse motors 7 and 8 which rotate ball screws 9 and 10 engaging with nuts 11 and 12, respectively, so that the tables may be horizontally moved in the directions of X and Y through the nut 11 secured to the upper table 5 and the nut 12 secured to the lower table 6. On the upper table 5, the substrates 2 and 3 are secured at a given interval, which is equal to the interval between a bonding agent applying apparatus 90 and a chip component engaging apparatus 120.

The moving mechanism for the substrates 2 and 3 will be described hereinafter. A bracket 14 with a carrying pawl 4 for maintaining the given location of the substrate 2 and a carrying pawl 13 for maintaining the given location of the substrate 3 secured thereon is slidably engaged with a splined shaft 17 whose ends are supported by bearings 15 and 16 on arms provided on a base body 22 of the electronic component engaging apparatus. One end of the splined shaft 17 is secured to the intermediate portion of a rotary lever 18. A cylinder 19 is mounted at one end of the rotary lever 18 to rotate the rotary lever 18 together with the splined shaft 17. Another cylinder 20 for shifting the bracket 14 is secured to the other end of the rotary lever 18. The distal end of the piston rod 18' of the cylinder 20 is coupled to the bracket 14 with the carrying pawls 4 and 13 which can move forward the substrates 2 and 3 by a given pitch through the thrust of the cylinder 20.

When the forwarding operation of the cylinder 20 is over, the operation of the cylinder 18 rotates the splined shaft 17 to separate the carrying pawls 4 and 13 from the substrates 2 and 3. An unloader unit 21 takes the delivered substrate 3 out of the central portion of the apparatus in a known manner.

The bonding material applying apparatus 90 and the chip component engaging apparatus 120 to be operated by a driving unit 30 of the same system are disposed at an interval equal to the interval at which the substrates 2 and 3 are supported on the upper table 5. The applying apparatus 90 and the engaging apparatus 120 are secured on the body base 22 so that the apparatuses 90 and 120 can simultaneously operate with respect to the substrates through the simultaneous movement of the substrates 2 and 3. A chip component feed unit 160, independently of the upper and lower tables 5, 6, the bonding material apparatus 90 and the engaging apparatus 120, is slidably guided by guide shafts 23 and 24 on the body base 22 along which the chip component feed unit 160 is movable in the direction of an arrow A in Fig. 1 through the rotation of a ball screw 26, which is secured to the chip components feed unit 160, and is driven by a pulse motor 25 secured to the body base 22.

A plurality of taping cassettes 170 and straight advance feeders 200 of the vibration type for the chip components are disposed on the chip component feed unit 160 to ensure the stable feed of the various types of chip components to the substrates. In addition, operation controlling boxes 27 and 28 for the apparatus are mounted on the front portion of the body base 22, and the control unit 29 thereof is incorporated inside the apparatus.

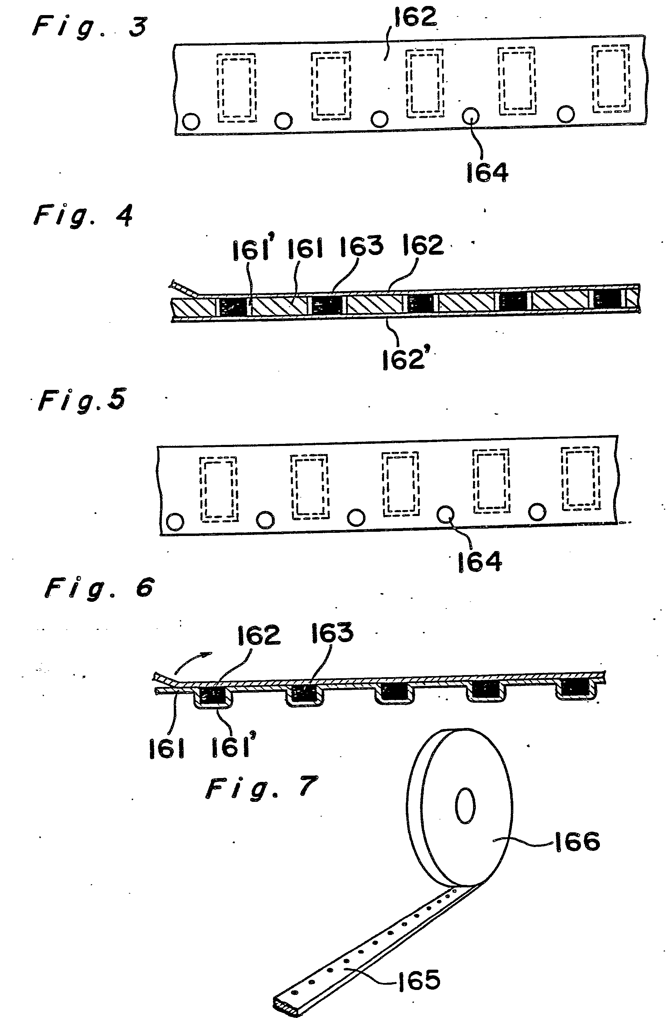

A taping cassette 170 mounted on the table 160' of the chip component feed unit 160 shown in Fig. 1 will be described hereinafter in detail. Figs. 3 to 6 show one example of a condition where the chip components for use in the apparatus of the present invention are disposed in a line at given pitches within a form of tape shape. Referring to Figs. 3 and 4, a ribbon-like strip of material (hereinafter referred to as tape) 161 is made of a flexible strip plate and is provided, at equal pitches along its longitudinal direction, with receiving holes 161' for accommodating the chip components therein. Each of the receiving holes 161' has a chip component 163 accommodated therein. A pair of flexible sheets or films 162 and 162' for covering the receiving holes 161' are pasted, respectively, on the opposed faces of the accommodating tape 161 to prevent the chip components 163 from slipping out of the receiving holes 161'. But one of covering sheets pasted on the top surface of the tape is adapted to be torn off easily from the tape by a tearing-off operation to enable the chip components to be taken out of the receiving holes 161'.

Also, round perforations 164 for engaging the feeding pawl of a feeding machine are provided in line along the edge of the tape corresponding, in location, to the pitches of the chip components 163.

Referring to Fig. 5 and Fig. 6, an accommodating tape 161 of another type is provided, at equal pitches, with concave recess 161', each accommodating a chip component 163 therein. A covering sheet 162 is pasted on the accommodating tape 161, for easy tearing-off operation, to prevent the chip components 163 from slipping out. Also, perforations 164 are provided in the accommodating tape 161, corresponding to the pitches of the chip components 163 for the mechanical feeding operation.

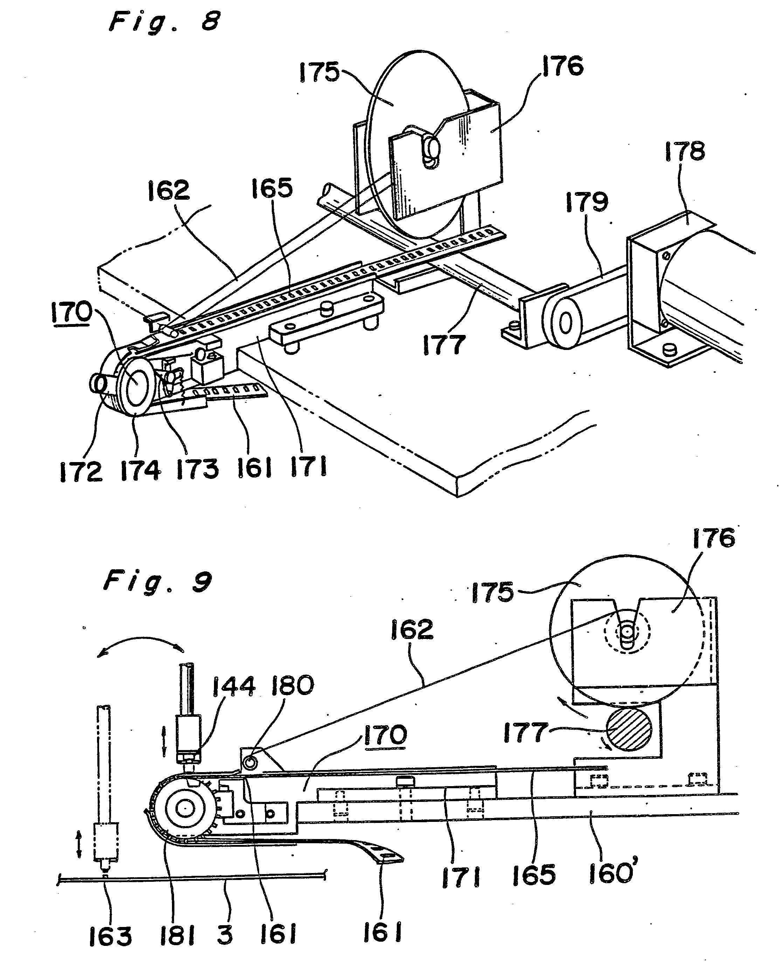

As shown in Fig. 7, the chip components 163 disposed in a tape construction 165 of a shape as shown in Figs. 3 to 6 (hereinafter referred to as taped chip components) are wound to a reel 166 with one end drawn to the outside, which is set in a proper position on the table 160' of Fig. 1. A taping cassette 170 for delivering the taped chip components 163 from the reel 166 will be described with reference to Fig. 8 to Fig. 11.

Referring to Fig. 8, the taping cassette 170 is composed of a body 171, a lever 172 adapted for intermittently delivering the taped chip components 163 by a given pitch, a feed pawl 173 for one way operation of the lever, a ratchet wheel 174 to be engaged with the pawl, a take-up reel 175 for tearing off the covering sheet 162, a reel guide 176 associated with the reel 175, a rotary shaft 177 for imparting the winding-up rotating-force to the reel 175, a motor 178 for driving the rotary shaft 177, a belt 179, etc.

Fig. 9 shows the positional relationship between the taping cassette 170 and a vacuum chuck 144 for engaging the chip components 163, Referring to Fig. 9, the tape construction 165 is separated, by a pin 180, into the accommodating tape 161 with the chip components 163 and the covering sheet 162. The accommodating tape 161 is forwardly delivered through the intermittent rotation of a ratchet wheel 181, while the covering tape 162 is sequentially wound by a reel 175, which is rotated by the rotary shaft 177. When the intermittent delivery of the accommodating tape 161 is in inoperative position, the rotary shaft 177 and the reel 175 are in slipping engagement with respect to each other. The vacuum chuck 144 is disposed in a given position near the ratchet 181 above the substrate 3 to suck up the chip components 163 from the accommodating tape 161.

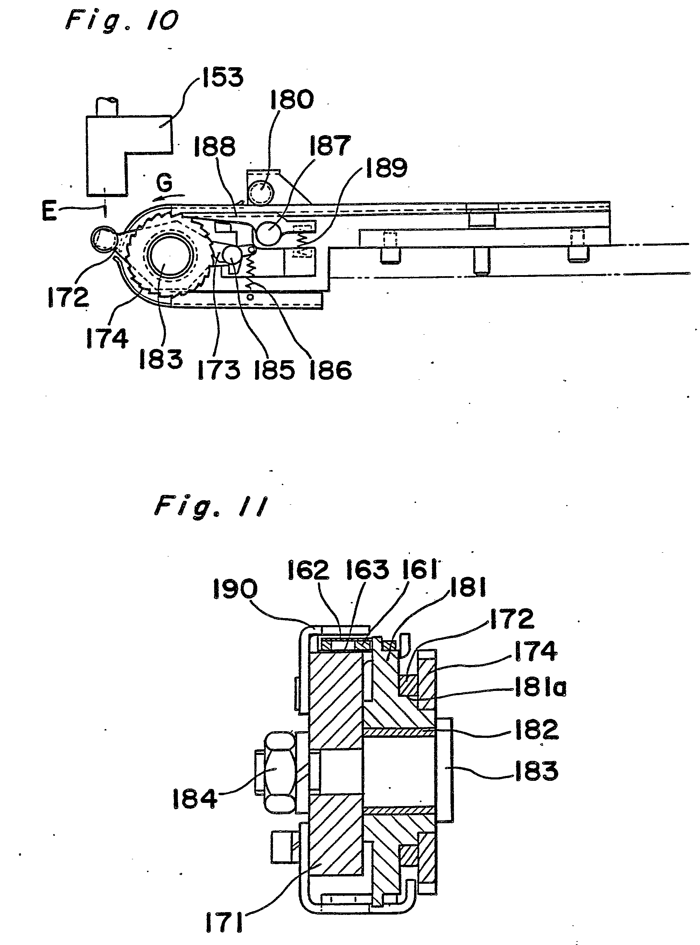

The intermittent delivery mechanism for the accommodating tape 161 in the taping cassette 170 will be described hereinafter with reference to Figs. 10 and 11. Referring to the drawings, the lever 172 is rotatably engaged into the boss 181a of the ratchet 181, and the ratchet 174 is concentrically inserted securely under pressure into the ratchet 181. The ratchet 181 can rotate around a rotary shaft 183 through a bush 182, the rotary shaft 183 being mounted on the body 171 by a hexagonal nut 184. A feed pawl 183 is rotatably mounted on one end of the lever 172 with a support point pin 185 and is rotatable around the support point pin 185, and is urged by a tension spring 186 to rotate in a clockwise direction. Also, a rotatable stopper 188 which is rotatably supported, by a support pin 187, in a given location of the body 171 is urged by a compression spring 189 into pressure contact against ratchet 174 thereby preventing the ratchet 174 from being rotated clockwise in Fig. 10. Referring to Fig. 11, a cover 190 is mounted on the body 171 to prevent the chip components 163 from slipping out of the accommodating holes of the accommodating tape 161. The operation will be described with reference to Fig. 10. When a hammer 153 (part of the component locating means 120) depresses the tip end of the lever 172 in the direction of an arrow E, the feed pawl 173 rotates together with the lever 172 to rotate the ratchet 174, by a given pitch, in the direction of an arrow G. After the given pitch rotation of the ratchet 174, the stopper pawl 188 engages the ratchet 174 to prevent the ratchet 174 from effecting its reverse rotation. Once the urging pressure against the lever 172 by the hammer 153 is released, the lever 172 is restored to its original condition by the tension spring 186. At this time, the feed pawl 173 retreats, by one pitch, in its engagement with the ratchet 174. Thus, the pressing operation of the lever 172 allows the ratchet 174 to be intermittently rotatable in a direction by a given pitch. Namely, in Fig. 11, the rotating force from the ratchet 174 is transmitted to the ratchet 181 to intermittently deliver the accommodating tape 161 by a given pitch.

The advantages of the present apparatus are that it is more effective in the mounting of the chip components to the circuit substrate for the reasons listed below.

(1) A special apparatus such as a screen printing press or the like is not required for the process prior to the engaging operation.

(2) The substrate can be easily prepared, since the substrate coated with a bonding material is handled only within the engaging apparatus.

(3) The bonding material coating and the electronic component engagement are performed within the same apparatus.

4. For supplying the components, a simple tape having identical chip components arranged thereon is employed. By merely preparing such tapes for the kinds required for mounting onto the substrates, it is possible to mount the necessary kinds of chip components at required portions on one substrate. When it is required to change the chip component engaging positions on the substrate, such alterations may be readily effected.

(5) The stable feed of the chip components can be made by the use of taped chip components.

**Claims**

1. An apparatus for mounting electronic components onto substrates including
   component locating means for picking up electronic components and placing them onto a first substrate;
   substrate support means for supporting said substrate at a predetermined location relative to said component locating means, said substrate support means being provided with means for altering the relative, x, y-location thereof with respect to said component locating means;
   component feeding means provided with a plurality of component feeding devices for sequentially feeding the components to be picked up by said component locating means;
   and driving means for driving said component feeding means which causes the plurality of component feeding devices to move relatively with respect to said component locating means, to bring said component feeding means in a predetermined order, into a position at which the required component can be picked up by said component locating means, characterized in that
   1. a) said components (163, 165) are accommodated on and spaced at predetermined intervals along component accommodating tapes (161);
   b) said component feeding devices (170) include means (172—189) for feeding said tapes by predetermined pitches, corresponding to said predetermined intervals;
   2. a) a bonding agent applying means (90) is provided for supplying bonding agent to component mounting locations on a substrate;
   b) said bonding agent applying means is located at a predetermined interval from said component locating means (120);
   3. said substrate support means (5) is adapted to support a second substrate adjacent the bonding agent applying means at an interval from the first substrate corresponding to said predetermined interval between said bonding agent applying means and said component locating means for corresponding x—y location alteration and is further provided with means independent of said means for altering the x—y location for advancing the second substrate over said predetermined interval and simultaneously bringing a third substrate into the position previously occupied by the second substrate.

2. Apparatus according to claim 1, characterised in that said tapes are provided with a covering tape and said means (170) for feeding said tapes (161) include means (175—180) for peeling off said covering tape (162) to exposed said components.

## Revendications

1. Appareil pour le montage de composants électroniques sur des substrats, comprenant:
— un moyen de positionnement de composant permettant de prélever des composants électroniques et de les placer sur un premier substrat;
— un moyen de support de substrat destiné au support du substrat à un emplacement prédéterminé par rapport au moyen de positionnement de composant, ce moyen de support de substrat comportant un moyen pour modifier son emplacement x, y par rapport au moyen de positionnement de composant;
— un moyen d'alimentation en composant comportant une pluralité d'organes d'alimentation en composant destinés à fournir séquentiellement les composants devant être prélevés par le moyen de positionnement de composant;
— et un moyen d'entraînement destiné à entraîner le moyen d'alimentation en composant, qui provoque le déplacement de la pluralité d'organes d'alimentation en composant par rapport au moyen de positionnement de composant, dans le but d'amener le moyen d'alimentation en composant dans un ordre prédéterminé, jusqu'à une position où le composant requis peut être prélevé par le moyen de positionnement de composant, caractérisé en ce que:
1. a) les composants (163, 165) sont reçus le long de bandes de réception de composant (161) et placés à des intervalles déterminés dans ces bandes;
b) les organes d'alimentation en composant (170) comprennent un moyen (172—189) pour faire avancer les bandes suivant des pas prédéterminés, correspondant aux intervalles prédéterminés;
2. a) un moyen d'application d'agent de liaison (90) est prévu pour fournir de l'agent de liaison aux emplacements de montage des composants sur un substrat;
b) le moyen d'application d'agent de liaison est situé à un intervalle prédéterminé par rapport au moyen de positionnement de composant (120);
3. le moyen de support de substrat (5) est destiné à supporter un second substrat contigu au moyen d'application d'agent de liaison à un certain intervalle par rapport au premier substrat correspondant à un intervalle prédéterminé entre le moyen d'application d'agent de liaison et le moyen de positionnement de composant pour une modification correspondante de l'emplacement x—y, et comporte d'autre part un moyen indépendant des moyens permettant de modifier l'emplacement x—y pour faire avancer le second substrat suivant l'intervalle prédéterminé et amener simultanément un troisième substrat dans la position occupée précédemment par le second substrat.

2. Appareil selon la revendication 1, caractérisé en ce que les bandes comportent une bande de couverture, et en ce que le moyen (170) permettant de faire avancer les bandes (161) comprend un moyen (175—180) pour détacher la bande de couverture (162) et mettre les composants à nu.

## Patentansprüche

1. Vorrichtung zum Bestücken von Trägern mit elektronischen Bauteilen,
mit einer Bauteil-Anordnungseinrichtung zum Aufnehmen elektronischer Bauteile und zu deren Plazierung auf einem ersten Träger;
mit einer Träger-Unterstützungseinrichtung zum Halten des Trägers an einer vorbestimmten Position relativ zu der Bauteil-Anordnungseinrichtung, wobei die Träger-Unterstützungseinrichtung Vorkehrungen zur Änderung dieser relativen x, y-Position aufweist;
mit einer Bauteil-Zuführeinrichtung, die eine Mehrzahl von Bauteil-Zuführgeräten zum aufeinanderfolgenden Nachschieben der von der Bauteil-Anordnungseinrichtung aufzunehmenden Bauteile aufweist;
und mit einem Antrieb zum Antreiben der Bauteil-Anordnungseinrichtung, welche die Mehrzahl der Bauteil-Zuführgeräte relativ zur Bauteil-Anordnungseinrichtung bewegt und die Bauteil-Zuführeinrichtung in vorbestimmter Reihenfolge in eine Stellung bringt, in der das benötigte Bauteil von der Bauteil-Anordnungseinrichtung aufgenommen werden kann, dadurch gekennzeichnet, daß
1. a) die Bauteile (163, 165) mit vorbestimmten Intervallen entlang Bauteil-Aufnahmebändern (161) angeordnet sind;
b) die Bauteil-Zuführgeräte (170) Mittel (172—189) zum Nachschieben der Bänder um vorbestimmte, den vorbestimmten Intervallen entsprechende Schritte aufweisen;
2. a) eine Befestigungsmittel-Auftragseinrichtung (90) zum Aufbringen von Befestigungsmittel auf einen Träger an den Bauteil-Bestückungspositionen vorgesehen ist,
b) und zwar in einem vorbestimmten Abstand von der Bauteil-Anordnungseinrichtung (120);
3. die Träger-Unterstützungseinrichtung (5) zur Abstützung eines zweiten Trägers nahe der Befestigungsmittel-Auftragseinrichtung ausgebildet ist, und zwar in einem Abstand vom ersten Träger, welcher dem vorbestimmten Abstand zwischen der Befestigungsmittel-Auftragseinrichtung und der Bauteil-Anordnungseinrichtung zwecks entsprechender x, y-Positionsänderung entspricht, sowie ferner Mittel aufweist, welche unabhängig von der Einrichtung zur Änderung der x, y-Position sind, um den zweiten Träger über den vorbestimmten Abstand vorzuschieben und gleichzeitig einen dritten Träger in die zuvor vom zweiten Träger eingenommene Stellung zu bringen.

2. Vorrichtung nach Anspruch 1, dadurch gekennzeichnet, daß die Bänder mit einem Abdeckband versehen sind und die Einrichtungen (170) zum Vorschieben der Bänder (161) Mittel (175—180) zum Abziehen des Abdeckbandes (162) und Offenlegen der Bauteile aufweisen.

Fig. 1

Fig. 2

0016368

Fig. 3

162

164

Fig. 4

161' 161 163 162

162'

Fig.5

164

Fig. 6

162 163

161 161'

Fig. 7

166

165

3

Fig. 8

Fig. 9

Fig. 10

Fig. 11